# EUROPÄISCHE PATENTSCHRIFT

(11) **EP 3 679 384 B1**
(45) Veröffentlichungstag und Bekanntmachung des Hinweises auf die Patenterteilung: **31.05.2023**
(21) Anmeldenummer: 18769621.6
(22) Anmeldetag: 06.09.2018
(51) Int. Cl.: G01R 33/30

(54) **DRUCKSTABILE 3D GEDRUCKTE NMR-DURCHFLUSSZELLE**
PRESSURE-RESISTANT, 3D PRINTED NMR FLOW CELL
CELLULE D'ÉCOULEMENT, POUR LA RÉSONANCE MAGNÉTIQUE NUCLÉAIRE, IMPRIMÉE EN 3D ET RÉSISTANT À LA PRESSION

(30) Priorität: 06.09.2017 DE 102017120510
(43) Veröffentlichungstag der Anmeldung: 15.07.2020
(73) Patentinhaber: Bundesrepublik Deutschland, vertreten durch die Bundesministerin für Wirtschaft und Energie, diese vertreten durch den Präsidenten der Bundesanst., 12205 Berlin (DE); Lapp Insulators Alumina GmbH, 96257 Redwitz (DE)
(72) Erfinder: KERN, Simon, 10245 Berlin (DE); MEYER, Klas, 12489 Berlin (DE); MAIWALD, Michael, 10247 Berlin (DE); WAMPERS, Holger, 96257 Redwitz (DE); BORNEMANN, Martin, 14532 Kleinmachnow (DE)
(74) Vertreter: Zimmermann & Partner Patentanwälte mbB
(86) Internationale Anmeldenummer: PCT/EP2018/074007
(87) Internationale Veröffentlichungsnummer: WO 2019/048545

(56) Entgegenhaltungen:
- EP-A1- 2 551 692
- JP-A- 2002 116 243
- JP-A- 2003 075 523
- US-A- 5 867 026
- US-B2- 7 145 340
- CURRAN S A ET AL: "DESIGN AND OPTIMIZATION OF AN NMR FLOW CELL FOR A COMMERCIAL NMR SPECTROMETER", APPLIED SPECTROSCOPY, THE SOCIETY FOR APPLIED SPECTROSCOPY. BALTIMORE, US, Bd. 41, Nr. 8, 1987, Seiten 1450-1454, XP000940979, ISSN: 0003-7028, DOI: 10.1366/0003702874447266

## Beschreibung

Die Erfindung liegt auf dem Gebiet chemisch inerter und druckstabiler Durchflusszellen für die Prozessanalytik mittels NMR, beispielsweise in der chemisch/pharmazeutischen Industrie.

Für Niederfeld-NMR-Spektrometer sind kommerzielle Durchflusszellen aus Glas oder Polymermaterialien bekannt, die durch bewegliche Dichtungen mit der Probenzuführungsleitung verbunden sind.

Aus JP 2003 075523 A ist eine Durchflusszelle bekannt, welche einen kreiszylindrischen keramischen Grundkörper mit gegenüberliegenden Aufnahmen für jeweils eine Kapillare aufweist. Die Anordnung ist für hohe Drucke ausgelegt.

Bewegliche Verbindungen zwischen Durchflusszelle und Probenzuführungsleitung gelten im Bereich des Explosionsschutzes als potenziell unsicher und bedeuten hinsichtlich Sicherheit und Leckagedetektion einen enormen Mehraufwand in einer Produktionsumgebung der chemischen Industrie.

Es ist daher Aufgabe der vorliegenden Erfindung, eine zylindrische Durchflusszelle bereitzustellen, die insbesondere im Radiofrequenzbereich durchlässig für elektromagnetische Strahlung ist und eine zentrale Aufweitung aufweist. Die Durchflusszelle muss über einen druckstabilen und im Sinne des Explosionsschutzes "unfehlbaren" Übergang auf gebräuchliche Edelstahlleitungen verfügen.

Diese Aufgabe wird gelöst durch eine Durchflusszelle nach Anspruch 1. Weitere Ausführungsformen, Modifikationen und Verbesserungen ergeben sich anhand der folgenden Beschreibung und aus den beigefügten Ansprüchen.

Erfindungsgemäss wird eine Durchflusszelle für die Kemspinresonanzspektroskopie vorgeschlagen. Gemäss einer der beiden in Anspruch 1 definierten Ausgestaltungen umfasst die Durchflusszelle einen kreiszylindrischen keramischen Grundkörper sowie zwei einander auf einer zentralen Symmetrieachse des kreiszylindrischen Grundkörpers gegenüberliegende Aufnahmen für jeweils eine Kapillare, wobei die jeweils eine Kapillare mit dem kreiszylindrischen keramischen Grundkörper im Sinne eines Explosionsschutzes unfehlbar stoffschlüssig verbunden ist.

Dies ist vorteilhaft für den Einsatz als online-Messtechnik für chemische Reaktionssyteme hinsichtlich des Erlangens quantitativer und struktureller Information über die einzelnen Reaktanden.

Erfindungsgemäss umfasst die Durchflusszelle weiter zwei einander gegenüberliegende Hülsen, wobei ein Innendurchmesser der Aufnahmen und ein Außendurchmesser der Hülsen angepasst ist zur Ausbildung eines Lotspaltes für eine Lotverbindung zwischen dem keramischen Grundkörper und jeweils einer der Hülsen, wobei die jeweils eine Kapillare über eine Schweißverbindung mit der Hülse verbunden ist.

Die mit den verwendeten Verbindungstechniken Löten und Schweißen geschaffenen Verbindungen sind im Sinne des Explosionsschutzes unfehlbare Verbindungen der einzelnen Elemente der Durchflusszelle.

Gemäß einer Ausführungsform ist eine Wandstärke eines zwischen den Aufnahmen entlang der Symmetrieachse gebildeten Hohlraumes in einem zentralen Bereich zwischen den Aufnahmen konstant gering und vergrößert sich jeweils zur Aufnahme hin allmählich, indem sich ein Innendurchmesser des Hohlraumes bis auf einen Innendurchmesser der Kapillare verringert, sodass die Durchflusszelle kein Totvolumen aufweist und ein Fluidstrom in der Durchflusszelle laminar ist.

Es ist eine wichtige Eigenschaft einer Durchflusszelle, kein Totvolumen aufzuweisen, sodass - nach entsprechender Kalibrierung - Prozessströme fehlerfrei analysiert werden können.

Erfindungsgemäss widersteht die Durchflusszelle einem hydrostatischen Druck von mindestens 3 MPa (30 bar), insbesondere einem Druck von mindestens 50 MPa (500 bar), bevorzugt einem Druck von bis zu 75 MPa (750 bar).

Die Durchflusszelle ist vorteilhaft für die Untersuchung von Reaktionssystemen mit hohen Drücken geeignet, da eine in der Durchflusszelle befindliche Probe direkt - ohne Druckentspannung der Probe - gemessen werden kann.

Gemäß einer weiteren Ausführungsform ist der kreiszylindrische Grundkörper der Durchflusszelle mittels 3D-Druck aus einem Keramikschlicker, umfassend ZrO₂ und anschließendem Sintern gefertigt. Erfindungsgemäss bestehen die Hülsen aus Titan.

Diese Ausführungsform ist vorteilhaft für die Fertigung durch 3D-Druck, da der kreiszylindrische Grundkörper aus einem Stück gefertigt werden kann und die Herstellung ohne weitere Fügeverfahren einzelner Keramikteile auskommt.

Gemäß einer weiteren Ausführungsform weist der zentrale Bereich der Durchflusszelle entlang der Symmetrieachse zumindest über eine Länge von zumindest 50 mm eine konstant geringe Wandstärke auf, wobei er die konstant geringe Wandstärke 0,725 mm nicht überschreitet.

Diese Ausführungsform gewährleistet ein optimales Signal/Rausch-Verhältnis des NMR-Spektrometers.

Erfindungsgemäss ist die jeweils eine Kapillare eine Stahlkapillare.

Stahlkapillaren werden üblicherweise in der in-line-Prozesskontrolle eingesetzt, sodass eine Überwachung von Reaktionsprodukten mittels NMR erleichtert wird.

Gemäß einer weiteren Ausführungsform verringert sich der Innendurchmesser des Hohlraumes im zentralen Bereich über eine Länge von 7 mm außerhalb des zentralen Bereichs bis auf den Innendurchmesser der Stahlkapillare.

Vorteilhaft wird so die Ausbildung von Totvolumina verhindert.

Gemäß einer weiteren Ausführungsform umfasst die Durchflusszelle weiterhin einen statischen Mischer, welcher im keramischen Grundkörper integriert ist. Gemäß bevorzugter Ausgestaltungen des Grundkörpers wird der Mischer durch mindestens eine der folgenden Strukturen verwirklicht: i) einen Raupenmischer, ii) einen T-Mischer, iii) einen Schikanenmischer, iv) einen Interdigitalmischer und v) einen ST-Mischer.

Diese Mischertypen haben sich als besonders vorteilhaft erwiesen. Sie weisen ein kleines internes Volumen bei hoher Mischeffizienz auf und erlauben ein intensives Mischen von reaktiven Substanzen und Lösungsmitteln unmittelbar vor dem aktiven Messvolumen des NMR-Spektrometers. So kommt es zu einer effizienten Verteilung der Reaktanden in der Lösung, so dass optimaler Stofftransport gegeben ist. Vorteilhaft wird so die Untersuchung von Reaktionen mit geringer Reaktionszeit (< 1 min) aufgrund der geringen Totzeit ermöglicht. Zusätzlich wird die Beeinflussung durch die Verweilzeitverteilung aufgrund des laminaren Strömungsprofils zwischen dem Ort der Reaktion und dem Messbereich deutlich verringert. Insbesondere bevorzugt ist ein Raupenmischer.

Ein weiterer Aspekt der vorliegenden Erfindung betrifft ein Herstellungsverfahren für eine Durchflusszelle nach Anspruch 1 oder einer der vorbezeichneten Ausführungsformen. Das Herstellungsverfahren ist in Anspruch 7 definiert und umfasst u.a. die folgenden Schritte:
- Bereitstellen eines mit einem organischen Binder versehenen Keramikschlickers umfassend ein durch Y₂O₃ stabilisiertes ZrO₂;
- schichtweise strukturiertes Aushärten des Keramikschlickers zu einem Grünkörper mittels lokaler Exposition gegenüber Laserenergie gemäß Steuerdaten, welche die Durchflusszelle nach einem SLICE-Prozess schichtweise wiedergeben;
- Freistellen des Grünkörpers auf einer Bauplattform;
- thermisches Entbindern des Grünkörpers;
- Sintern des entbinderten Grünkörpers in einer oxidierenden Atmosphäre bei einer Temperatur von 1400°C;
- Abkühlen des beim Sintern ausgebildeten Sinterkörpers.

Der kreiszylindrische Grundkörper der Messzelle, der eine Keramik umfasst, umfasst eine röhrenförmige Messkaverne und zwei einander auf einer zentralen Symmetrieachse der Durchflusszelle an gegenüberliegenden Enden der röhrenförmigen Messkaverne angeordnete keramische Anschlussstücke für jeweils zumindest eine metallische Kapillare, wobei die zumindest jeweils eine metallische Kapillare mit dem jeweiligen keramischen Anschlussstück im Sinne eines Explosionsschutzes unfehlbar stoffschlüssig verbunden ist. Ebenso sind die zwei keramischen Anschlussstücke mit jeweils einem der beiden einander gegenüber liegenden Enden der röhrenförmigen Messkaverne im Sinne eines Explosionsschutzes unfehlbar stoffschlüssig verbunden. Sind die beiden Anschlussstücke gemeinsam mit der röhrenförmigen Messkaverne einstückig mittels 3D Druck gefertigt, so ergibt sich deren im Sinne eines Explosionsschutzes unfehlbare stoffschlüssige Verbindung selbstredend, da der dann vorliegende einstückige keramische Grundkörper so ausgelegt ist, dass er als solcher explosionssicher ist und einem gegenüber dem Umgebungsdruck erhöhten Innendruck zuverlässig widersteht.

Dies ist vorteilhaft für den Einsatz als online-Messtechnik für unter erhöhtem Druck stehende Komponenten chemischer Reaktionssysteme hinsichtlich des Erlangens quantitativer und struktureller Information über die einzelnen Reaktanden geeignet.

Die keramischen Anschlussstücke weisen Aufnahmen für die jeweils zumindest eine metallische Kapillare auf.

Vorteilhaft wird dadurch die Gewährleistung der im Sinne des Explosionsschutzes unfehlbaren Verbindung der Kapillaren zu den keramischen Anschlussstücken erleichtert.

Gemäß einer Ausführungsform ist eine Wandstärke eines zwischen den Aufnahmen entlang der Symmetrieachse gebildeten Hohlraumes, der die Messkaverne umfasst, konstant gering. Zur jeweiligen Aufnahme hin vergrößert sich die Wandstärke allmählich, indem sich ein Innendurchmesser des Hohlraumes bis auf einen Innendurchmesser der Kapillare verringert, sodass die Durchflusszelle kein Totvolumen aufweist.

Es ist eine wichtige Eigenschaft einer Durchflusszelle, kein Totvolumen aufzuweisen, sodass - nach entsprechender Kalibrierung - Prozessströme fehlerfrei analysiert werden können.

Gemäß einer Ausführungsform bildet die röhrenförmige Messkaverne mit den keramischen Anschlussstücken einen einstückigen keramischen Grundkörper.

Die einstückige Ausbildung der vorgeschlagenen Durchflusszelle erhöht deren Zuverlässigkeit für Messungen direkt an einem unter erhöhtem Druck stehenden Fluid. Insbesondere kann die NMR-Spektroskopie im Sinne einer Online-Prozesskontrolle als leistungsstarke Analysemethode zur direkten Überwachung eines chemischen Prozesses verwendet werden, der bei einem erhöhten hydrostatischen Druck abläuft.

Erfindungsgemäss umfassen die keramischen Anschlussstücke weiter eine Hülse, wobei ein Innendurchmesser der Aufnahme und ein Außendurchmesser der Hülse angepasst ist zur Ausbildung eines Lotspaltes für eine Lotverbindung zwischen dem Grundkörper und jeweils einer der Hülsen, wobei die jeweils eine Kapillare über eine Schweißverbindung mit der jeweiligen Hülse verbunden ist.

Vorteilhaft sind die mit den verwendeten Verbindungstechniken Löten und Schweißen geschaffenen Verbindungen im Sinne des Explosionsschutzes unfehlbare Verbindungen der einzelnen Elemente der Durchflusszelle.

Gemäß einer beispielhaften Ausführungsform verringert sich der Innendurchmesser des Hohlraumes im zentralen Bereich der Durchflusszelle über eine Länge von 7 mm außerhalb des zentralen Bereichs bis auf den Innendurchmesser der Stahlkapillare.

Vorteilhaft wird so die Ausbildung von Totvolumina verhindert.

Gemäß einer Ausführungsform umfasst der einstückige keramische Grundkörper, umfassend die röhrenförmige Messkaverne und die keramischen Anschlussstücke, eine Zirkonoxidkeramik. Die Hülsen umfassen Titan und sind mit dem einstückigen keramischen Grundkörper durch eine Lotverbindung verbunden.

Eine Durchflussmesszelle gemäß dieser Ausführungsform lässt sich ist vorteilhaft durch 3D-Druck fertigen, wobei der Grundkörper zusammen mit den Anschlussstücken in einem Stück zunächst zu einem Grünkörper gesintert werden kann und die Herstellung der Durchflusszelle so ohne weitere Fügeverfahren einzelner Keramikteile auskommt. Für das Ausbilden einer stoffschlüssigen Fügeverbindung zwischen den Kapillaren und den Hülsen sowie zwischen den Hülsen und der Keramik sind bewährte Fügemittel, beispielsweise Lote, bekannt.

Gemäss einer anderen in Anspruch 1 definierten Ausgestaltung der Durchflusszelle umfasst die röhrenförmige Messkaverne ein Saphir-Röhrchen und die beiden keramischen Anschlussstücke sind im Sinne des Explosionsschutzes unfehlbar stoffschlüssig mit dem Saphir-Röhrchen verbunden.

Vorteilhaft weist ein Saphir-Röhrchen eine geringe Rauhigkeit auf, sodass ein Rauschen bei der Messung niedrig ausfällt und eine Probe in der Duchflusszelle ein Messsignal hoher Güte liefert.

Gemäß einer Ausführungsform weist das Saphirröhrchen, d.h. der zentrale Bereich der Durchflusszelle entlang der Symmetrieachse zumindest über eine Länge von zumindest 50 mm eine konstant geringe Wandstärke auf, wobei die konstant geringe Wandstärke 0,725 mm nicht überschreitet.

Diese Ausführungsform gewährleistet ein optimales Signal/Rausch-Verhältnis beim Einsatz der Durchflussmesszelle in einem NMR-Spektrometer.

Stahlkapillaren werden üblicherweise in der in-line-Prozesskontrolle eingesetzt, sodass eine Überwachung von Reaktionsprodukten mittels NMR erleichtert wird.

Gemäß einer Ausführungsform umfasst die Durchflusszelle weiterhin einen statischen Mischer, welcher im keramischen Grundkörper integriert ist. Gemäß bevorzugter Ausgestaltungen des Grundkörpers wird der Mischer durch mindestens eine der folgenden Strukturen verwirklicht: i) einen Raupenmischer, ii) einen T-Mischer, iii) einen Schikanenmischer, iv) einen Interdigitalmischer, v) einen SMX-Mischer oder vi) einen ST-Mischer.

Diese Mischertypen haben sich als besonders vorteilhaft erwiesen. Sie weisen ein kleines internes Volumen bei hoher Mischeffizienz auf und erlauben ein intensives Mischen von reaktiven Substanzen und Lösungsmitteln unmittelbar vor dem aktiven Messvolumen des NMR-Spektrometers. So kommt es zu einer effizienten Verteilung der Reaktanden in der Lösung, so dass optimaler Stofftransport gegeben ist. Vorteilhaft wird so die Untersuchung von Reaktionen mit geringer Reaktionszeit (< 1 min) aufgrund der geringen Totzeit ermöglicht. Zusätzlich wird die Beeinflussung durch die Verweilzeitverteilung aufgrund des laminaren Strömungsprofils zwischen dem Ort der Reaktion und dem Messbereich deutlich verringert. Insbesondere bevorzugt ist ein Raupenmischer.

Falls die röhrenförmige Messkaverne ein Saphir-Röhrchen ist, werden die unfehlbaren Verbindungen zwischen den zwei keramischen Anschlussstücken und der röhrenförmigen Messkaverne mit einem Glaslot hergestellt.

Vorteilhaft weisen entsprechende Saphirröhren eine Duchlässigkeit sogar im UV-Bereich auf, sodass die erhaltene Durchfluss-Messzelle nicht nur für die NMR-Spektroskopie, sondern auch für optische Messverfahren einsetzbar ist.

Gemäß Verwendungsanspruch 10 wird vorgeschlagen, die oben beschriebene Durchflusszelle in einem Messverfahren zu verwenden, wobei eine Probe in der Durchflusszelle während des Messverfahrens einem Druck ausgesetzt ist, der ausgewählt ist unter: einem Druck von mindestens 3 MPa (30 bar), einem Druck von mindestens 50 MPa (500 bar), einem Druck bis maximal 75 MPa (750 bar).

Gemäß einem praktischen Ausführungsbeispiel wird die NMR-Durchflusszelle im 3D Druck in einem Stück gefertigt und mittels Metall-Keramik-Fügeverfahren direkt an eine Edelstahlleitung angebunden. Hierbei wird die Keramik (ZrO₂) mit einer Titanhülse verlötet. Dazu wurde gemäß einem praktischen Ausführungsbeispiel TiCuSil-Lot genutzt. Die Zusammensetzung des Lotes (Masse-%) ist wie folgt: Ag - 68,8; Cu - 26,7; Ti - 4,5. Danach wird die Titanhülse mit einem Rohr aus V4A-Stahl verschweißt. Damit entsprechen die Werkstoffe und Fügetechniken den Anforderungen an ein - im Sinne des Explosionsschutzes - unfehlbares Behälter-System (infallible containment system). Die Anforderungen umfassen: Das Behältersystem soll aus metallischen, keramischen oder Glas Röhrchen, Rohren oder Behältern bestehen, die keine beweglichen Verbindungen umfassen. Verbindungen sollen durch Schweißen, Löten, Glas-zu-Metall-Dichtungen oder eutektische Verfahren ausgeführt sein (IEC 60079-2).

Gemäß einem zweiten praktischen Ausführungsbeispiel wird die Durchflusszelle zumindest teilweise im 3D Druck gefertigt. Das zweite praktische Ausführungsbeispiel ist gegenüber dem vorstehend beschriebenen Ausführungsbeispiel modifiziert. Die vorgeschlagene druckstabile NMR-Durchflusszelle umfasst demnach eine aus Saphir bestehende Messkaverne (d.h. ein Saphir-Röhrchen) mit zwei keramischen Anschlussstücken ("Einlass" und "Auslass") für zu- und abführende Stahlkapillaren. Ein erstes keramisches Anschlussstück "Einlass") ist eingerichtet für die Zuführung von zwei Fluiden zu einem im ersten keramischen Anschlussstück angeordneten statischen Mischer. Das im fertiggestellten Zustand der Messzelle von der Messkaverne wegweisende, die zwei zu mischenden Fluidströme in zwei angeschlossenen Kapillaren zuführende erste Ende des ersten keramischen Anschlussstücks ist hierzu mit zwei, zu einer zentralen Symmetrieachse des ersten keramischen Anschlussstücks symmetrisch angeordneten Aufnahmen für den Anschluss der zwei zuführenden Kapillaren versehen. Die besagte Symmetrieachse des ersten keramischen Anschlussstücks setzt sich in der zentralen Symmetrieachse der fertiggestellten Durchflusszelle fort. Die besagten Kapillaren am ersten keramischen Anschlussstück dienen für den Transport von zwei Fluidströmen (z.B. einem Prozessstrom und einem Reagenz) in den unmittelbar nachfolgenden und ebenso im ersten keramischen Anschlussstück angeordneten statischen Mischer. Der Innendurchmesser des Mischer-Ausganges ist identisch mit dem Innendurchmesser des Saphir-Röhrchens, beispielsweise 4 mm. Das erste keramische Anschlussstück umfasst also zwei Aufnahmen für zuführende Stahlkapillaren, einen statischen Mischer und einen für die Anbindung an ein Ende des Saphir-Röhrchens vorgesehene Mischer-Ausgang. Das gesamte erste Anschlussstück, auch der Mischer ist, wie zuvor beschrieben, einstückig mittels 3D-Druck aus Keramikschlicker gefertigt. Die Anbindung der zwei zuführenden Edelstahlkapillaren an die zwei einseitig angeordneten Aufnahmen im ersten keramischen Anschlussstück erfolgte mit dem zuvor beschrieben TiCuSil-Lot. Der Mischer-Ausgang im ersten keramischen Anschlussstück weist einen Innendurchmesser auf, der jenem der Messkaverne (Saphirröhrchen) gleicht. Er ist auf Stoß fluidisch dichtend und im Sinne des Explosionsschutzes unfehlbar mit einem ersten Ende des Saphirrohres, das die Messkaverne bildet, unter Verwendung eines Glaslotes der folgenden Zusammensetzung (Angaben in Masse-%; Anteile >1 Masse-%) verbunden: SiO₂ - 67,4; Al₂O₃ - 18,4; CaO - 4,91; K₂O - 6,33 und Na₂O - 1,37. Am anderen Ende des als Messkaverne dienenden Saphirröhrchens ist ein zweites keramisches Anschlussstück ("Auslass") mit ebendiesem Lot fluidisch dichtend und im Sinne des Explosionsschutzes unfehlbar stoffschlüssig verbunden. Das zweite keramische Anschlussstück umfasst eine in der fertiggestellten Messzelle dem Saphir-Röhrchen zugewandte Öffnung, deren Innendurchmesser identisch mit dem Innendurchmesser des Saphir-Röhrchens ist. Der Innendurchmesser der zentralen Öffnung im zweiten keramischen Anschlussstück verjüngt sich in Richtung der Aufnahme für die abführende Kapillare allmählich bis auf deren Durchmesser. Die abführende (Stahl-) Kapillare ist wiederum, wie die beiden zuführenden Kapillaren, mit der Keramik unter Verwendung des bereits mit dem ersten Ausführungsbeispiel beschriebenen TiCuSil-Lotes druckstabil fluidisch dichtend - und im Sinne des Explosionsschutzes unfehlbar - verbunden. Vorteile dieser Ausführungsform ergeben sich aus der gegenüber einer vollständig mittels 3D-Druck erzeugten (einstückigen) Durchflusszelle verringerten Rauheit im Bereich des eigentlichen Messfensters (Messkaverne). Vorteilhaft ergibt sich für die Saphir-Messzelle gemäß der zweiten in Anspruch 1 definierten Option eine höhere Signalgüte bei deutlich verringertem Rauschen. Die einseitige Anordnung von zwei zuführenden Kapillaren, deren Stoffströme in einen mittels 3D-Druck gefertigten statischen Mischer münden, der wiederrum unmittelbar an der Messkaverne angebunden ist, ermöglicht die unmittelbare Erfassung von im Mischer gebildeten Reaktionsprodukten in der Messkaverne. Die einstückige Fertigung des ersten keramischen Anschlussstücks mit dem Mischer ermöglicht einen völlig totvolumenfreien Innenraum. Insbesondere kann durch Mischung zweier, oder gar mehrerer, Fluide ein Vorteil dadurch erzielt werden, dass die Reaktion der Fluide unter strömungsoptimierten Bedingungen abläuft und das Reaktionsprodukt unmittelbar in der direkt angebundenen Messkaverne (Messvolumen) messbar ist. So ergeben sich für eine Analyse mittels NMR-Spektroskopie eine verbesserte Homogenisierung und Vormagnetisierung. Der Einsatz derartiger Messzellen bringt auch verfahrenstechnische Vorteile: Zeitgewinn durch Optimierung des Versuchsablaufs auf Grund einer schnelleren Einstellung eines stationären Reaktionszustands. Das ermöglicht ein schnelleres Abarbeiten von vielen Betriebspunkten, wenn NMR als Analysenmethode direkt an Produktströme chemischer Prozesse gekoppelt ist.

Um ein optimales Signal/Rausch-Verhältnis des NMR-Spektrometers zu erhalten, weist die zylindrische Zelle in der Mitte, die in den aktiven Bereich des Spektrometers eingebracht wird (also die Messkaverne, die von der NMR-Messspule umschlossen wird), eine Aufweitung auf. Optional ist im Bereich der Aufweitung oder benachbart zu diesem ein im keramischen Grundkörper integrierter Mischer angeordnet. Im Bereich der Aufweitung ist die Wandstärke der Messzelle bis zu einem minimalen Wanddurchmesser reduziert, bei dem die Druckfestigkeit noch gewährleistet ist. Um das Gesamtvolumen der Zelle möglichst klein zu halten, soll danach der Innendurchmesser der Durchflusszelle wieder verjüngt werden, beispielsweise auf 1-2 mm.

Die beiliegenden Zeichnungen veranschaulichen Ausführungsformen und dienen zusammen mit der Beschreibung der Erläuterung der Prinzipien der Erfindung. Die Elemente der Zeichnungen sind relativ zueinander und nicht notwendigerweise maßstabsgetreu. Gleiche Bezugszeichen bezeichnen entsprechend ähnliche Teile.

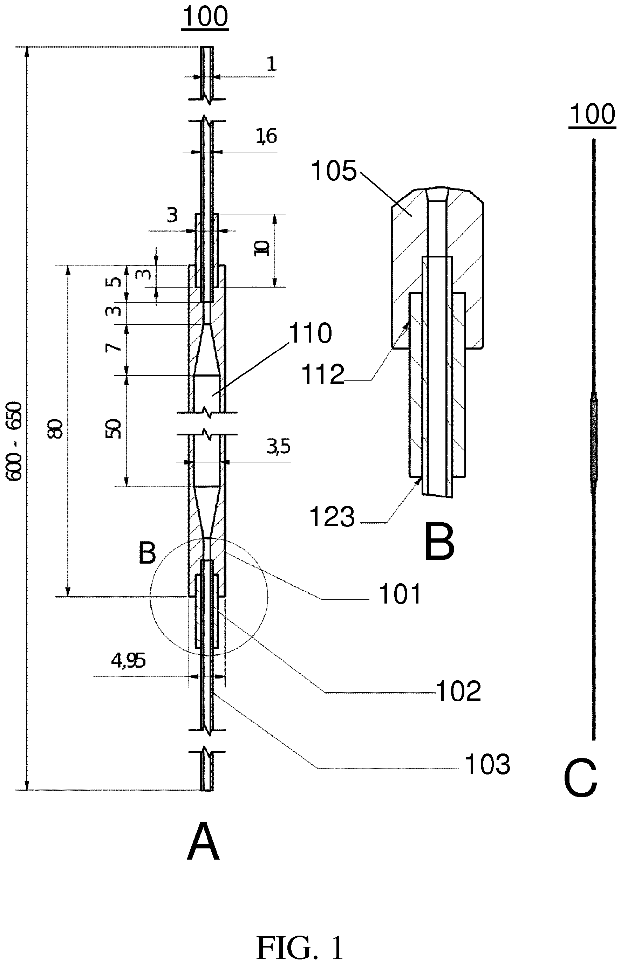

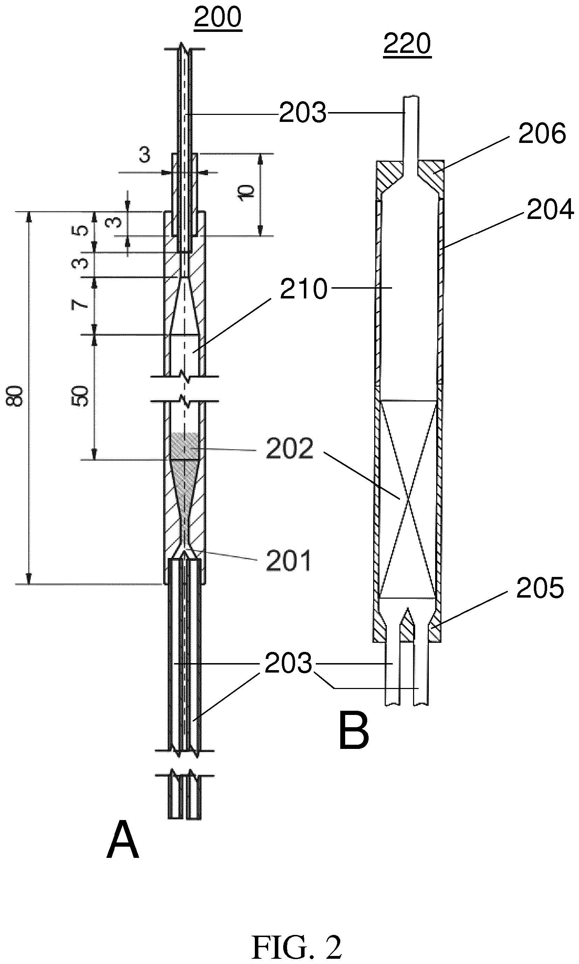

Die Figur 1 weist drei Teilbilder, A, B und C auf. **Fig. 1A** zeigte eine mit beispielhaften Bemaßungen versehene Schnittansicht der mit Fluidanschlüssen versehenen Durchflusszelle **100.** Die Durchflusszelle **100** umfasst einen langgestreckten rotationssymmetrischen Messkammern-Grundkörper **101,** der mittels 3D-Druck zunächst aus einem Keramikschlicker gefertigt und danach gesintert wird. Die einander gegenüberliegenden Fluidanschlüsse der Messkammer münden in eine Buchse **102,** die erfindungsgemäss aus Titan gefertigt ist. Durch die Buchse **102** hindurch bis in den Grundkörper **101** hinein ragt eine, beispielsweise für die HPLC typischerweise verwendete, Stahlkapillare **103,** beispielsweise umfassend V4A-Stahl. Die Buchse **102** ist an einem dem Grundkörper zugewandten Ende mit dem Grundkörper **101** der Messzelle verlötet und an ihrem anderen Ende mit dem Kapillarrohr **103** verschweißt. Die Figur 2 zeigt eine weitere Ausführungsform der vorgeschlagenen Durchflusszelle 200 welche einen statischen Mischer umfasst.

Aus **Fig. 1A** ist auch ersichtlich, dass sich der Fluidanschluss im Inneren des Grundkörpers 101 wie bereits beschrieben aufweitet, indem eine Wandstärke über einen Abschnitt in Richtung zur Mitte hin bis auf einen Minimalwert abnimmt.

Das Teilbild **Fig. 1B** zeigt in einer vergrößerten Ansicht den mit einem Kreis umrandeten und dem kleineren Buchstaben "B" bezeichneten Ausschnitt aus **Fig. 1A,** bzw. das Anschlussstück **105** des keramischen Grundkörpers **101.** Bei der gezeigten Ausführungsform **100** sind die zwei einander gegenüberliegenden Anschlussstücke **105** für je eine Kapillare **103** gemeinsam mit der dazwischen liegenden dünnwandigen Messkavität **110** einstückig in Form eines keramischen Grundkörpers 101 mittels 3D-Druck gefertigt.

Insbesondere sind die jeweiligen Fügeflächen der Lotverbindung **112** und der Schweißverbindung **123** gezeigt. Es ist außerdem ersichtlich, dass der Innendurchmesser des Kapillarrohres **103** identisch ist mit dem Innendurchmesser des Fluidanschlusses (Anschlussstück **105)** des Messzellen-Grundkörpers **101.** Vorteilhaft treten dadurch keine Verwirbelungen in einer die Messzelle durchströmenden Probe auf, die Strömung bleibt laminar.

**Fig. 1C** zeigt eine Gesamtansicht der Messzelle 100 mit Zuleitungen.

Die **Fig. 2** zeigt in zwei Teilbildern A und B je eine Ausführungsform der NMR-Durchflusszelle **200** und **220,** welche im Vergleich zu der in Fig. 1 gezeigten Durchflusszelle 100 durch einen statischen Mischer **202** ergänzt ist. Durch diese Anordnung können reaktive Substanzen und Lösungsmittel unmittelbar vor dem aktiven Messvolumen des NMR-Spektrometers (d.h. im ausgeweiteten Bereich der Durchflusszelle) , z.B. in einer Y-Verbindung **201,** zusammengeführt und vermischt werden, und anschießend im Messvolumen, d.h. in der Messkaverne **210,** detektiert werden.

**Fig. 2A** zeigt eine mittels 3D-Druck hergestellte einstückige Keramik-Messzelle **200.** **Fig. 2B** zeigt eine Messzelle **220** umfassend eine gesonderte, beispielsweise aus Saphir bestehende, Messkaverne **210.** Ebenso kann die gesondert gekennzeichnete Messkaverne **210** aus einem andersartigen Keramikschlicker als jenem, der für die Anschlussstücke **205, 206** verwendet wurde, in einem durchgängigen 3D-Druckverfahren hergestellt sein. An einem ersten Ende der Messkaverne **210** ist ein erstes 3D-gedrucktes keramisches Anschlussstück **205** mit zwei Aufnahmen (Ausnehmungen, nicht im Detail gezeigt) für zuführende Stahlkapillaren **203** unfehlbar angefügt. Am gegenüberliegenden zweiten Ende der Messkaverne ist ein zweites 3D-gedrucktes keramisches Anschlussstück **206,** umfassend eine Aufnahme für eine abführende (Stahl-) Kapillare **203** unfehlbar stoffschlüssig angefügt. Im Innenraum des ersten keramischen Anschlussstücks **205,** d.h. der Zuführung **205,** ist ein statischer Mischer **202** ausgebildet. Der statische Mischer **202** umfasst in Strömungsrichtung hintereinander und zueinander versetzt angeordnete Prellflächen (hier nicht gesondert dargestellte Mischelemente). Das erste keramische Anschlussstück **205,** umfassend zwei Ausnehmungen für die zwei zuführenden Kapillaren **203** und den im Innenraum ausgebildeten statischen Mischer **202,** ist vollständig (einstückig) mittels 3D-Druck gefertigt. Die im Sinne des Explosionsschutzes unfehlbar gefügten Lotverbindungen der drei Stahlkapillaren zu den korrespondierenden Anschlüssen der keramischen Anschlussteile **205, 206** sind in der schematischen **Fig. 2B** nicht gesondert dargestellt.

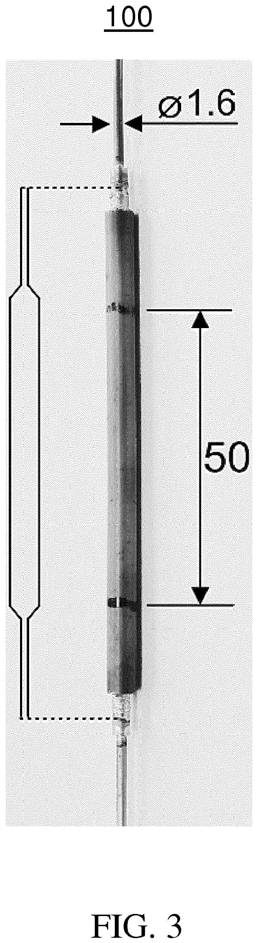

**Fig. 3** zeigt eine Fotografie der mittels 3D-Druck aus Keramik gefertigten Messzelle **100** wie in **Fig. 1** schematisch gezeigt mit Kapillaren **103, 203,** die jeweils mit Titanhülsen **102** verlötet sind, welche ihrerseits wiederum mit dem einstückigen keramischen Grundkörper **101** verschweisst sind (vgl. oben). Größenangaben in mm.

Gemäß einer beispielhaften praktischen Ausführungsform weist der kreiszylindrische Grundkörper 101 der NMR-Durchflusszelle 100 einen Außendurchmesser von 4,95 mm und eine Länge von 80 mm auf. Die Hülsen 102 haben gemäß dieser beispielhaften Ausführungsform einen Außendurchmesser von 3 mm und eine Länge von 10 mm und bestehen aus Titan. Die im Grundkörper 101 vorgesehenen Aufnahmen nehmen die Hülsen 102 jeweils bis auf eine Tiefe von 3 mm auf. Die mit der Hülse 102 verschweißte Stahlkapillare 103 hat einen Außendurchmesser von 3 mm und eine innere Weite von 1,6 mm. Damit ist die Kapillare **103, 203** über gebräuchliche Edelstahlfittings fluidisch dichtend mit einem Prozessstrom verbindbar.

Die beschriebene und in den Figuren beispielhaft gezeigte NMR-Durchflusszelle ist druckstabil für Fluiddrucke von bis zu 75 MPa (750 bar) und kann über die zuführenden Stahlkapillaren direkt über gebräuchliche metallische Klemmringverbindungen an Prozessströme angebunden werden.

Gemäß den für den Explosionsschutz maßgebenden ATEX-Richtlinien gelten Keramikmaterialien, welche an Edelstahlleitungen mittels Hartlötverfahren oder Schweißen angebunden sind als "unfehlbar". Vor diesem Hintergrund wird die Zertifizierung von Online-NMR-Spektrometern mit der hier vorgeschlagenen keramischen Messzelle enorm vereinfacht. Im Gegensatz hierzu müssen alle zurzeit auf dem Markt befindlichen Durchflusszellen als "Systeme mit limiterter Freisetzung" zertifiziert werden. Somit kann durch die beschriebene Erfindung ein Online-NMR-Spektrometer in einer industriellen Umgebung sicher betrieben werden, ohne zuvor ein aufwendiges Zertifizierungsverfahren durchlaufen zu müssen.

### Bezugszeichenliste

- 100, 200, 220: Duchflussmesszelle
- 101: Grundkörper
- 102: Hülse
- 103: Kapillare
- 105: Keramisches Anschlussstück
- 110,210: Messkaverne
- 112: Lotverbindung
- 123: Schweißverbindung
- 201: Y-Verbindung
- 202: Statischer Mischer
- 204: Saphirrohr
- 205: Erstes keramisches Anschlussstück
- 206: Zweites keramisches Anschlussstück

## Patentansprüche

1. Durchflusszelle (100, 200) für die Kernspinresonanzspektroskopie (NMR),
- umfassend einen kreiszylindrischen keramischen Grundkörper (101) mit einem entlang einer Symmetrieachse in einem zentralen Bereich gebildeten Hohlraum und zwei einander auf einer zentralen Symmetrieachse des kreiszylindrischen keramischen Grundkörpers (101) gegenüberliegenden Aufnahmen für jeweils eine Stahlkapillare (103), weiter umfassend zwei Titanhülsen (102), wobei ein Innendurchmesser der Aufnahmen und ein Außendurchmesser der Titanhülsen (102) angepasst ist zur Ausbildung eines Lotspaltes für eine Lotverbindung zwischen dem keramischen Grundkörper (101) und jeweils einer der Titanhülsen (102) und die jeweils eine Stahlkapillare (103) über eine Schweißverbindung mit der entsprechenden Titanhülse (102) verbunden ist, um eine im Sinne eines Explosionsschutzes unfehlbar stoffschlüssige Verbindung zwischen jeder Stahlkapillare und dem kreiszylindrischen keramischen Grundkörper zu erreichen;
oder
- umfassend eine aus Saphir bestehende röhrenförmige Messkaverne mit zwei einander auf einer zentralen Symmetrieachse der Durchflusszelle gegenüberliegenden Enden der röhrenförmigen Messkaverne angeordneten keramischen Anschlussstücken für jeweils eine Stahlkapillare (103);
wobei die Stahlkapillaren (103) mit den jeweiligen keramischen Anschlussstücken über im Sinne eines Explosionsschutzes unfehlbar gefügte Lotverbindungen stoffschlüssig verbunden sind, und
wobei die Durchflusszelle (100, 200) einem hydrostatischen Druck von mindestens 3 MPa (30 bar), insbesondere einem Druck von mindestens 50 MPa (500 bar), bevorzugt einem Druck von bis zu 75 MPa (750 bar) standhält.

2. Durchflusszelle (100, 200) nach Anspruch 1, wobei eine Wandstärke des Hohlraumes in dem zentralen Bereich zwischen den Aufnahmen konstant gering ist und sich jeweils zur Aufnahme hin allmählich vergrößert, indem sich ein Innendurchmesser des Hohlraumes bis auf einen Innendurchmesser der Stahlkapillare (103) verringert, sodass die Durchflusszelle (100) kein Totvolumen aufweist und ein Fluidstrom in der Durchflusszelle (100) laminar ist.

3. Durchflusszelle (100, 200) nach einem der vorstehenden Ansprüche, wobei der kreiszylindrische keramische Grundkörper (101) mittels 3D-Druck aus einem Keramikschlicker, umfassend ZrO₂ und anschließendem Sintern gefertigt ist.

4. Durchflusszelle (100, 200) nach einem der Ansprüche 1 bis 3, wobei der zentrale Bereich mit einer konstant geringen Wandstärke entlang der Symmetrieachse eine Länge von zumindest 50 mm aufweist und die konstant geringe Wandstärke 0.725 mm nicht überschreitet.

5. Durchflusszelle (100, 200) nach einem der vorstehenden Ansprüche, wobei sich der Innendurchmesser des Hohlraumes im zentralen Bereich über eine Länge von 7 mm außerhalb des zentralen Bereichs bis auf den Innendurchmesser der Stahlkapillare (103) verringert.

6. Durchflusszelle (100, 200) nach einem der vorstehenden Ansprüche, weiter umfassend einen statischen Mischer (202), welcher im keramischen Grundkörper (101) integriert ist, wobei der Mischer (202) ausgewählt ist unter: einem Raupenmischer, einem T-Mischer, einem Schikanenmischer, einem Interdigitalmischer und einem ST-Mischer.

7. Herstellungsverfahren für eine Durchflusszelle (100, 200, 220) nach einem der Ansprüche 1 bis 6, umfassend:
- Bereitstellen eines mit einem organischen Binder versehenen Keramikschlickers umfassend ein durch Y₂O₃ stabilisiertes ZrO₂;
- schichtweise strukturiertes Aushärten des Keramikschlickers zu einem Grünkörper mittels lokaler Exposition gegenüber Laserenergie gemäß nach einem Slice-Prozess gewonnenen Steuerdaten, welche den einstückigen keramischen Grundkörper (101) umfassend zwei einander auf der zentralen Symmetrieachse des kreiszylindrischen keramischen Grundkörpers (101) gegenüberliegenden Aufnahmen (105) schichtweise wiedergeben;
- Freistellen des Grünkörpers auf einer Bauplattform;
- thermisches Entbindern des Grünkörpers;
- Sintern des thermisch entbinderten Grünkörpers in einer oxidierenden Atmosphäre bei einer Temperatur von 1400°C und Abkühlen des beim Sintern ausgebildeten Sinterkörpers;
- Hartlöten und damit Herstellen stoffschlüssiger, im Sinne des Explosionsschutzes unfehlbarer Verbindungen zwischen den Aufnahmen und jeweils einer Titanhülse (102), wobei ein Innendurchmesser der Aufnahmen und ein Außendurchmesser der Titanhülsen (102) angepasst ist zur Ausbildung eines Lotspaltes für eine Lotverbindung zwischen dem keramischen Grundkörper (101) und jeweils einer der Titanhülsen (102) durch Ausbilden einer Lotverbindung zwischen dem Grundkörper (101) und jeweils einer der Hülsen (102); und
Schweißen und damit Herstellen stoffschlüssiger, im Sinne des Explosionsschutzes unfehlbarer Verbindungen jeweils zwischen einer der Titanhülsen (102) und einer Stahlkapillare (103) durch eine Schweißverbindung;
oder
- Bereitstellen einer röhrenförmige Messkaverne (110, 210) umfassend ein Saphirröhrchen und
- Hartlöten und damit Herstellen stoffschlüssiger, im Sinne des Explosionsschutzes unfehlbarer Verbindungen zwischen Enden der röhrenförmigen Messkaverne (110, 210) und jeweils einem gesinterten keramischen Anschlussstück (105, 205, 206) sowie zwischen jedem gesinterten keramischen Anschlussstück (105, 205, 206) und der entsprechenden Stahlkapillare (103).

8. Herstellungsverfahren nach Anspruch 7,
wobei das schichtweise strukturierte Aushärten ein Ausbilden eines statischen Mischers (202) umfasst,
wobei der statische Mischer (202) ausgewählt ist unter: einem Raupenmischer, einem T-Mischer, einem Schikanenmischer, einem Interdigitalmischer, einem SMX-Mischer und einem ST-Mischer.

9. Verwendung einer Durchflusszelle (100, 220, 220) in einem Messverfahren,
wobei eine Probe in der Durchflusszelle (100, 200, 220) während des Messverfahrens einem Druck ausgesetzt ist, der ausgewählt ist unter: einem Druck von mindestens 3 MPa (30 bar), einem Druck von mindestens 50 MPa (500 bar), einem Druck bis maximal 75 MPa (750 bar),
wobei die Durchflusszelle (100, 200, 220) eine Durchflusszelle (100, 200, 220) für die Kernspinresonanzspektroskopie (NMR) gemäß zumindest einem der Ansprüche 1 bis 6 ist.

## Claims

1. Flow cell (100, 200) for nuclear magnetic resonance spectrometry (NMR),
- comprising a circular cylindrical ceramic main body (101) comprising a cavity formed in a central region along an axis of symmetry and two receptacles, one for each steel capillary (103), that are opposite one another on a central axis of symmetry of the circular cylindrical ceramic main body (101), further comprising two titanium sleeves (102), wherein an internal diameter of the receptacles and an external diameter of the titanium sleeves (102) is adapted to form a gap for a soldered joint between the ceramic main body (101) and one of the titanium sleeves (102) in each case, and each steel capillary (103) is connected to the corresponding titanium sleeve by a welded joint in order to obtain a material bond which is infallible in terms of explosion protection between each steel capillary and the circular cylindrical ceramic main body;
or
- comprising a tubular measurement cavern consisting of sapphire comprising two ceramic connecting pieces, one for each steel capillary (103), that are arranged at ends of the tubular measurement cavern that are opposite one another on a central axis of symmetry of the flow cell;
wherein the steel capillaries (103) are joined by a material bond to the respective ceramic connecting pieces by means of soldered joints that are joined infallibly in terms of explosion protection, and
wherein the flow cell (100, 200) withstands a hydrostatic pressure of at least 3 MPa (30 bar), in particular a pressure of at least 50 MPa (500 bar), preferably a pressure of up to 75 MPa (750 bar).

2. Flow cell (100, 200) according to claim 1, wherein a wall thickness of the cavity in the central region between the receptacles is constantly low and gradually increases toward each receptacle by an internal diameter of the cavity reducing to an internal diameter of the steel capillary (103) such that the flow cell (100) does not have a dead volume and a fluid flow in the flow cell (100) is laminar.

3. Flow cell (100, 200) according to any one of the preceding claims, wherein the circular cylindrical ceramic main body (101) is manufactured by means of 3D printing from a ceramic slip, containing ZrO₂, and subsequent sintering.

4. Flow cell (100, 200) according to any one of claims 1 to 3, wherein the central region having a constantly low wall thickness along the axis of symmetry has a length of at least 50 mm and the constantly low wall thickness does not exceed 0.725 mm.

5. Flow cell (100, 200) according to any one of the preceding claims, wherein the internal diameter of the cavity in the central region reduces over a length of 7 mm outside the central region to the internal diameter of the steel capillary (103).

6. Flow cell (100, 200) according to any one of the preceding claims, further comprising a static mixer (202), which is integrated in the ceramic main body (101), wherein the mixer (202) is selected from: a caterpillar mixer, a T-mixer, a chicane mixer, an interdigital mixer, and an ST-mixer.

7. Production method for a flow cell (100, 200) according to any one of claims 1 to 6, comprising:
- providing a ceramic slip, provided with an organic binder, containing ZrO₂ stabilized by Y₂O₃;
- curing the ceramic slip in a layered structure to form a green body by being locally exposed to laser energy in accordance with control data which have been obtained in a slice process and reproduce, layer by layer, the one-piece ceramic main body (101) comprising two receptacles (105) that are opposite one another on the central axis of symmetry of the circular cylindrical ceramic main body (101);
- providing the green body on a construction platform;
- thermally debinding the green body;
- sintering the thermally debound green body in an oxidizing atmosphere at a temperature of 1400°C and cooling the sintered body formed during the sintering;
- brazing and thus producing material bonds which are infallible in terms of explosion protection between the receptacles and one titanium sleeve (102) in each case, wherein an internal diameter of the receptacles and an external diameter of the titanium sleeves (102) is adapted to form a gap for a soldered joint between the ceramic main body (101) and one of the titanium sleeves (102) in each case by forming a soldered joint between the main body (101) and one of the sleeves (102) in each case; and
- welding and thus producing material bonds which are infallible in terms of explosion protection between one of the titanium sleeves (102) and a steel capillary (103) by a welded joint in each case;
or
- providing a tubular measurement cavern (110, 210) comprising a sapphire tube and
- brazing and thus producing material bonds which are infallible in terms of explosion protection between ends of the tubular measurement cavern (110, 210) and a sintered ceramic connecting piece (105, 205, 206) in each case as well as between each sintered ceramic connecting piece (105, 205, 206) and the corresponding steel capillary (103).

8. Production method according to claim 7,
wherein the curing in a layered structure comprises configuring a static mixer (202),
wherein the static mixer (202) is selected from: a caterpillar mixer, a T-mixer, a chicane mixer, an interdigital mixer, an SMX mixer, and an ST-mixer.

9. Use of a flow cell (100, 220, 220) in a measurement method,
wherein, during the measurement method, a sample in the flow cell (100, 200, 220) is subjected to a pressure selected from: a pressure of at least 3 MPa (30 bar), a pressure of at least 50 MPa (500 bar), a pressure of at most 75 MPa (750 bar), wherein the flow cell (100, 200, 220) is a flow cell (100, 200, 220) for nuclear magnetic resonance spectrometry (NMR) according to at least one of claims 1 to 6.

## Revendications

1. Cellule d'écoulement (100, 200) pour la spectroscopie à résonance magnétique nucléaire (RMN),
- comprenant un corps de base cylindrique en céramique (101) avec une cavité formée le long d'un axe de symétrie dans une zone centrale et deux logements qui se font face sur un axe de symétrie central du corps de base cylindrique en céramique (101), chacun pour un capillaire en acier (103), comprenant en outre deux manchons en titane (102), dans lequel un diamètre intérieur des logements et un diamètre extérieur des manchons en titane (102) sont adaptés à la réalisation d'un interstice de brasage pour une liaison par brasage entre le corps de base en céramique (101) et respectivement un des manchons en titane (102) et le capillaire en acier (103) est relié, par l'intermédiaire d'une liaison par soudure, avec le manchon en titane (102) correspondant, afin d'obtenir une liaison de matière infaillible en ce qui concerne la protection contre les explosions entre chaque capillaire en acier et le corps de base cylindrique en céramique ;
ou
- comprenant une cavité de mesure tubulaire en saphir, avec deux raccords en céramique, chacun pour un capillaire en acier (103), disposés avec deux extrémités, qui se font face sur un axe de symétrie central de la cellule d'écoulement, de la cavité de mesure tubulaire :
les capillaires en acier (103) étant reliés avec les raccords en céramique respectifs par des liaisons par brasage assemblées de manière infaillible en ce que concerne une protection contre les explosions, et
la cellule d'écoulement (100, 200) résistant à une pression hydrostatique d'au moins 3 MPa (30 bar), plus particulièrement une pression d'au moins 50 MPa (500 bar), de préférence à une pression jusqu'à 75 MPa (750 bar).

2. Cellule d'écoulement (100, 200) selon la revendication 1, dans lequel une épaisseur de paroi de la cavité dans la zone centrale entre les logements est faible de manière constante et augmente progressivement respectivement vers chaque logement en réduisant un diamètre intérieur de la cavité jusqu'à un diamètre intérieur des capillaires en acier (103), de façon à ce que la cellule d'écoulement (100) ne présente aucun volume mort et de façon à ce qu'un écoulement de fluide dans la cellule d'écoulement (100) soit laminaire.

3. Cellule d'écoulement (100, 200) selon l'une des revendications précédentes, dans laquelle le corps de base en céramique (101) est fabriqué par impression 3D à partir d'une barbotine en céramique comprenant du ZrO₂ et un frittage ultérieur.

4. Cellule d'écoulement (100, 200) selon l'une des revendications 1 à 3, dans laquelle la zone centrale avec une épaisseur de paroi constamment faible le long de l'axe de symétrie a une longueur d'au moins 50 mm et l'épaisseur de paroi constamment faible ne dépasse pas 0,725 mm.

5. Cellule d'écoulement (100, 200) selon l'une des revendications précédentes, dans laquelle le diamètre intérieur de la cavité diminue, dans la zone centrale, sur une longueur de 7 mm, hors de la zone centrale, jusqu'au diamètre intérieur des capillaires en acier (103).

6. Cellule d'écoulement (100, 200) selon l'une des revendications précédentes, comprenant en outre un mélangeur statique (202) qui est intégré dans le corps de base en céramique (101), dans lequel le mélangeur (202) est sélectionné parmi : un mélangeur à chenille, un mélangeur en T, un mélangeur à chicane, un mélangeur interdigital et un mélangeur ST.

7. Procédé de fabrication d'une cellule d'écoulement (100, 200, 300) selon l'une des revendications 1 à 6, comprenant :
- la fourniture d'une barbotine de céramique munie d'un liant organique, comprenant du ZrO₂ stabilisé par Y₂O₃ ;
- le durcissement structuré par couches de la barbotine de céramique en un corps de base grâce à une exposition locale à une énergie laser selon des données de contrôle obtenues selon un processus par tranches, qui reproduisent par couches le corps de base en céramique d'une seule pièce (101) comprenant deux logements (105) qui se font face sur l'axe de symétrie central du corps de base cylindrique en céramique (101) ;
- la libération du corps de base sur une plate-forme de construction ;
- l'élimination thermique du liant du corps de base ;
- le frittage du corps de base dont le liant a été éliminé de manière thermique dans une atmosphère oxydante à une température de 1400 °C et le refroidissement du corps fritté réalisé lors du frittage ;
- le brasage et donc la réalisation de liaisons de matière infaillibles en ce qui concerne la protection contre les explosions entre les logements et respectivement un manchon en titane (102), dans lequel un diamètre intérieur des logements et un diamètre extérieur des manchons en titane (102) est adapté à la réalisation d'un interstice de brasage pour une liaison par brasage entre le corps de base en céramique (101) et respectivement l'un des manchons en titane (102) par la réalisation d'une liaison par brasage entre le corps de base (101) et respectivement l'un des manchons (102) ; et
la soudure et donc la réalisation de liaisons par liaison de matière infaillibles en ce qui concerne la protection contre les explosions, respectivement entre l'un des manchons en titane (102) et un capillaire en acier (103) par une liaison soudée ;
ou
- la fourniture d'une cavité de mesure tubulaire (110, 210) comprend un tube en saphir et
- le brasage et donc la réalisation de liaisons de matière infaillibles en ce qui concerne la protection contre les explosions, entre les extrémités de la cavité de mesure tubulaire (110, 210) et respectivement un raccord en céramique frittée (105, 205, 206) ainsi qu'entre chaque pièce de raccordement en céramique frittée (105, 205, 206) et le capillaire en acier (103) correspondant.

8. Procédé de fabrication selon la revendication 7,
dans lequel le durcissement structuré par couches comprend une réalisation d'un mélangeur statique (202),
dans lequel le mélangeur statique (202) est sélectionné parmi : un mélangeur à chenille, un mélangeur en T, un mélangeur à chicane, un mélangeur interdigital, un mélangeur SMX et un mélangeur ST.

9. Utilisation d'une cellule d'écoulement (100, 220, 220) dans un procédé de mesure,
dans laquelle un échantillon dans la cellule d'écoulement (100, 200, 220) est soumis, pendant le procédé de mesure, à une pression qui est sélectionnée parmi : une pression d'au moins 3 MPa (30 bar), une pression d'au moins 50 MPa (500 bar), une pression jusqu'à 75 MPa (750 bar) maximum,
dans laquelle la cellule d'écoulement (100, 200, 220) est une cellule d'écoulement (100, 200, 220) pour une spectroscopie de résonance magnétique nucléaire (RMN) selon au moins l'une des revendications 1 à 6.
